# EUROPÄISCHE PATENTSCHRIFT

(11) **EP 0 595 881 B1**
(45) Veröffentlichungstag und Bekanntmachung des Hinweises auf die Patenterteilung: **02.04.1997**
(21) Anmeldenummer: 92915419.3
(22) Anmeldetag: 13.07.1992
(51) Int. Cl.: C11D 3/43, C11D 7/50, H05K 3/26

(54) **VERWENDUNG VON HALOGENKOHLENWASSERSTOFF-FREIEN REINIGUNGSMITTELN ZUR FLUXENTFERNUNG VON ELEKTRONISCHEN UND ELEKTRISCHEN BAUGRUPPEN**
USE OF HALOGENATED-FREE CLEANING AGENTS FOR REMOVAL OF FLUX AND SOLDER FROM ELECTRONIC AND ELECTRICAL ASSEMBLIES
UTILISATION DE COMPOSITIONS SANS HYDROCARBURES HALOGENES POUR NETTOYER DES ENSEMBLES ELECTRONIQUES ET ELECTRIQUES DES RESIDUS DE SOUDURE

(30) Priorität: 22.07.1991 DE 4124246
(43) Veröffentlichungstag der Anmeldung: 11.05.1994
(73) Patentinhaber: Henkel Kommanditgesellschaft auf Aktien, 40191 Düsseldorf (DE)
(72) Erfinder: GÖHAUSEN, Hans, Jürgen, D-4018 Langenfeld (DE)
(86) Internationale Anmeldenummer: EP9201588
(87) Internationale Veröffentlichungsnummer: WO9302173

(56) Entgegenhaltungen:
- DE-A- 2 545 149
- DE-A- 4 031 563
- FR-A- 2 486 535
- FR-A- 2 531 805

## Beschreibung

Die Erfindung betrifft die Verwendung von Halogenkohlenwasserstoff-freien, mit Wasser mischbaren Reinigungsmitteln für elektronische und elektrische Baugruppen zur Fluxent-fernung von Leiterplatten nach dem Löten.

Fluxmittel, auch Flußmittel genannt, auf Basis von Kolophonium sind grundsätzlich aus zwei unterschiedlichen chemischen Produktgruppen zusammengesetzt, nämlich aus relativ unpolaren, harzartigen Verbindungen, beispielsweise Kolophonium, und polaren Verbindungen, sogenannten Aktivatoren. Gemäß den chemischen Gesetzmäßigkeiten lösen sich die chemischen Verbindungen am besten in gleich gearteten Lösungsmitteln, also in unpolaren oder polaren Reinigern. Besondere Probleme ergeben sich im Stand der Technik, wenn die als Aktivatoren verwendeten Carbonsäuren in Konzentrationen von bis zu 35 % im Kolophonium enthalten sind und teilweise in Fluorkohlenwasserstoffen oder Chlorkohlenwasserstoffen überhaupt nicht, in Alkoholen nur schwer löslich sind. Dies führt oftmals zur Auflösung des Kolophoniums und Freilegung von weißen Rückständen der Aktivatoren, die, von der Isolationswirkung des Kolophoniums befreit, unter Einfluß der Luftfeuchtigkeit leitfähig und korrosiv werden können.

Für die Reinigung von elektronischen und elektrischen Baugruppen, insbesondere für die Entfernung von kolophoniumhaltigen Flußmitteln von Leiterplatten nach dem Löten, werden bis in jüngste Zeit überwiegend Fluorkohlenwasserstoffe eingesetzt. Im Hinblick auf das Problem der Zerstörung der Ozonschichten durch die Fluorchlorkohlenwasserstoffe hat man sich in jüngster Zeit um die Entwicklung alternativer Reinigungsmittel bemüht.

Die DE-A-23 16 720 beschreibt ein Reinigungsmittel zum Entfernen von kolophoniumhaltigen Rückständen auf elektrischen Geräten, das Kolophoniumreste und gegebenenfalls Aktivatoren weitgehend rückstandsfrei beseitigen soll und andererseits die bei elektrischen Schaltungen verwendeten Isolierstoffe und Metalle nicht störend angreift. Die Waschmittel lösung enthält insbesondere einen polaren, höherwertigen Alkohol, insbesondere Butylglykol oder N-Butanol, weiterhin einen polaren niederwertigen Alkohol, insbesondere Methanol oder Isopropanol, neben einem unpolaren Kohlenwasserstoff, insbesondere Trichlortrifluorethan oder Hexan, gegebenenfalls in Anwesenheit eines nichtionogenen Netzmittels. Zum einen wird durch die Verwendung des unpolaren Kohlenwasserstoffs ein nicht mit Wasser mischbares Reinigungsmittel erhalten. Zum anderen gilt es, den eingesetzten Fluorchlorkohlenwasserstoff wegen der ozonzerstörerischen Wirkung zu vermeiden. Darüber hinaus haben derartige Reiniger, wenn sie keine Fluorchlorkohlenwasserstoffe enthalten, außerordentlich niedrige Flammpunkte, die bei der Anwendung dieser Mittel entsprechende explosionsgeschützte Anlagen erforderlich machen.

Aus EP-A-0 120 319 ist ein Reinigungsmittel bekannt, das neben halogenierten Kohlenwasserstoffen auch nichthalogenierte Kohlenwasserstoffe, einen fluorierten Alkohol und gegebenenfalls weitere polare organische Lösungsmittel enthält. Aufgrund des Gehalts an halogenierten Kohlenwasserstoffen genügt dieses Reinigungsmittel nicht mehr den heutigen technischen Anforderungen.

Aus EP-A-0 416 763 ist die Reinigung von elektronischen Leiterplatten durch Einwirkung von Terpenen oder anderen nichthalogenierten Lösungsmitteln bekannt. Diese Reinigungsmittel haben jedoch einen außerordentlich niedrigen Flammpunkt, so daß bei der Anwendung entsprechende Explosionsschutzmaßnahmen vorgenommen werden müssen.

Die EP-A-0 419 089 beschreibt eine Reinigungsmittel-Zusammensetzung, die Dimethylcyclooctadien enthält.

Aus Römpps Chemie-Lexikon, 9. Auflage, Band 2 (1990), S. 923, Stichwort Diacetonalkohol, ist die Verwendung von Diacetonalkohol zur Lösung von Kolophonium und vielen Natur- und Kunstharzen bekannt.

Aus Chemical Abstracts, Vol. 114 (1991), Seite 139, Referat 114:84373g zu JP-A-90/202998 sind wasserfreie Lösungsmittelgemische bekannt, die aus Fluorchlorkohlenwasserstoffen und Ketonen bestehen. Unter anderem wird Diacetonalkohol neben den genannten Flurochlorkohlenwasserstoffen zur Fluxmittelentfernung eingesetzt.

Die FR-A-25 31 805 betrifft ein Verfahren zur Entfernung von Folien und Folienresten von Schirmträgern für Kathodenstrahlröhren, insbesondere zur Reinigung des Randes derartiger Schirmträger, durch Behandeln der Schirmträger mit einem Gemisch aus Wasser und mindestens einem Lösungsmittel, das Harze und Lackrohstoffe zu lösen vermag und mit anderen Lösungsmitteln und Wasser in beliebigen Verhältnissen mischbar ist. Als Lösungsmittel kommen hierbei Butyrolacton, Diacetonalkohol und/oder Diacetin in Frage sowie gegebenenfalls zusätzlich ein aliphatischer Alkohol. Gemäß einer bevorzugten Ausführungsform des Verfahrens wird ein Gemisch aus Butyrolacton, Wasser und Diacetonalkohol verwendet.

Demgegenüber bestand die Aufgabe der vorliegenden Erfindung darin, ein Halogenkohlenwasserstoff-freies, mit Wasser mischbares Reinigungsmittel für elektronische und elektrische Baugruppen bereitzustellen, das in der Lage ist, die in den Flußmitteln, insbesondere solchen auf Kolophoniumbasis enthaltenen polaren und unpolaren Stoffe ohne Verwendung von Fluorchlorkohlenwasserstoffen oder Chlorkohlenwasserstoffen sicher zu entfernen. Das Mittel sollte darüber-hinaus einen Flammpunkt oberhalb von 60 °C aufweisen, der ferner, je nach Einsatzgebiet, durch Zusatz von Wasser noch weiter erhöht werden kann. Weitere Anforderung aus der Technik ist die universelle Verwendbarkeit in Tauch/Flut-Anlagen, Ultraschallbädern und Spritzanlagen.

Auch ist erforderlich, daß das Mittel nach der Reinigung mit Wasser rückstandsfrei abspülbar sein sollte.

Es wurde gefunden, daß Halogenkohlenwasserstoff-freie, mit Wasser mischbare Reinigungsmittel auf der Basis von Diacetonalkohol sämtliche der vorgenannten Kriterien erfüllen können. Dementsprechend betrifft die vorliegende Erfindung in einer ersten Ausführungsform die Verwendung von Diacetonalkohol zur Reinigung elektronischer und elektrischer Baugruppen in Halogenkohlenwasserstoff-freien, mit Wasser mischbaren Reinigungsmitteln, dadurch gekennzeichnet, daß die Reinigungsmittel zur FluxmittelEntfernung nach dem Löten eingesetzt werden und Diacetonalkohol in Mengen von 30 bis 90 Gew.-%, bezogen auf das Reinigungsmittel, enthalten.

Es wurde ferner gefunden, daß neben der an sich bekannten guten Löslichkeit für Kolophonium auch die sogenannten "weißen Rückstände", die aus den Aktivatoren stammen, mit Hilfe von Diacetonalkohol praktisch vollständig entfernt werden konnten.

Es wurde weiterhin gefunden, daß im Sinne der vorliegenden Erfindung Diacetonalkohol nicht ausschließlich in wasserfreiem Medium eingesetzt werden muß; vielmehr kann Diacetonalkohol auch in Form einer wäßrigen Lösung eingesetzt werden. Bevorzugt enthalten derartige Lösungen wenigstens 30 Gew.-% Diacetonalkohol, bezogen auf das Reinigungsmittel. Besonders bevorzugt ist ein Gehalt an Diacetonalkohol, bezogen auf das Reinigungsmittel, von 30 bis 80 Gew.-%, insbesondere 50 bis 70 Gew.-%.

Reinigungsmittel im Sinne der vorliegenden Erfindung können weiterhin andere Additive enthalten. Beispielsweise können Tenside zugesetzt werden, um die Oberflächenspannung zu erniedrigen. Für diesen Zweck einsetzbare Tenside sind beispielsweise im Stand der Technik bekannte nichtionische und anionische Tenside. Als nichtionische Tenside seien hier beispielhaft genannt: Anlagerungsprodukte von Ethylenoxid und/oder Propylenoxid an Fettalkohole, Fettamine, Fettsäuren oder Alkylphenole; als anionische Tenside: Alkylbenzolsulfonate, Alkansulfate, Alkansulfonate, Fettalkoholethersulfate oder α-Sulfofettsäureester. Der Gehalt dieser für den genannten Zweck zu verwendenden Tenside beträgt bis zu 10 Gew.-%, bezogen auf das Reinigungsmittel, insbesondere 1 bis 5 Gew.-%.

Im Stand der Technik bekannt und als solche auch im Rahmen der vorliegenden Erfindung einsetzbar sind Korrosionsschutzmittel zur Hemmung der Korrosion auf der metallischen Oberfläche des zu reinigenden Gegenstandes. Beispielsweise können Kupfer-Korrosionsinhibitoren wie Benzotriazol und/oder Tolyltriazol eingesetzt werden. Ein geeigneter Konzentrationsbereich für diese Korrosionsinhibitor-Additive umfaßt 0,01 bis 5 Gew.-%, insbesondere bevorzugt 0,01 bis 1 Gew.-%.

Zur beschleunigten Ablösung von sauren Bestandteilen des Flußmittelharzes und insbesondere der verwendeten Aktivatoren, enthalten bevorzugte Reinigungsmittel im Sinne der vorliegenden Erfindung in einer weiteren Ausführungsform wasserlösliche organische Stickstoffbasen, insbesondere Triethanolamin. Besonders bevorzugt ist eine Menge von 1 bis 10 Gew.-%, insbesondere 2 bis 5 Gew.-%, der Stickstoffbasen, bezogen auf das Reinigungsmittel.

Weiterhin können die Reinigungsmittel im Sinne der vorliegenden Erfindung wasserlösliche, organische Lösungsmittel mit einer oder mehreren polaren Gruppen enthalten, insbesondere solche mit einer Alkohol-Gruppe und einem Siedepunkt von weniger als 300 °C, d.h. geradkettige Alkohole wie Butanol, Hexylalkohol, Decanol usw. und deren verzweigte Isomere, solche mit einer alicyclischen Alkoholgruppe, beispielhaft verkörpert durch Cyclohexanol, solche mit mehreren Alkoholgruppen, insbesondere Glykole, beispielsweise verkörpert durch Hexylenglykol, solche mit einer Ethergruppe, Glykolether, beispielsweise verkörpert durch Ethylenglykolmonobutylether, Ethylenglykoldibutylether usw., sowie solche mit einer Estergruppe, wie Glykolsäureester oder Glykolester, beispielsweise Ethylglykolacetat. Darüber hinaus können auch Lactone oder Lactame, insbesondere N-2-Methylpyrrolidon, in den Reinigungsmitteln enthalten sein. Ein wesentliches Kriterium der Auswahl dieser sogenannten Reinigungsverstärker ist der Flammpunkt der erhaltenen Reinigungsmittel, der durch den Zusatz dieser Reinigungsverstärker möglichst nicht auf Werte unterhalb 60 °C erniedrigt werden sollte. Diese wasserlöslichen Lösungsmittel-Reinigungsverstärker sind in den Reinigungsmitteln bevorzugt in einer Menge bis zu 30 Gew.-%, insbesondere in einer Menge von 5 bis 20 Gew.-%, bezogen auf das Reinigungsmittel, enthalten.

In einer weiteren Ausführungsform der vorliegenden Erfindung können die Reinigungsmittel bis zu 5 Gew.-%, insbesondere 1 bis 2 Gew.-% Alkalimetallphosphate als Buildersubstanzen, bezogen auf die Reinigungsmittel, enthalten. Unter dem Begriff "Alkalimetallphosphate" sind im Sinne der Erfindung Alkalimetall-orthophosphate, -pyrophosphate und -triphosphate (auch "Tripolyphosphate" genannt) zu verstehen. Von diesen werden jedoch erfindungsgemäß die Triphosphate bevorzugt, insbesondere das Kaliumtriphosphat oder Natriumtriphosphat.

Die vorstehenden Gewichtsprozent-Angaben zu den einzelnen Komponenten sind stets so zu verstehen, daß sie sich jeweils auf 100 Gew-.% ergänzen.

In der Praxis der Reinigung von Platten mit den gedruckten Schaltungen unter Einsatz des Reinigungsmittels im Sinne der vorliegenden Erfindung werden die Leiterplatten in das Reinigungsmittel eingetaucht, das zwischen Raumtemperatur und ca. 100 °C, insbesondere zwischen 30 °C und 70 °C gehalten wird; gewünschtenfalls können gleichzeitig zusätzlich Ultrabeschallung, Rühren, Vibration, Luftdurchblasen, Flüssigkeitsumwälzung durchgeführt werden; oder die Reinigung kann mittels Spritzen, Tauchen, Bürsten, Fluten sowie Kombinationen davon vorgenommen werden.

Nach dem Reinigen wie im Vorstehenden können die Leiterplatten entweder (aus dem Reinigerbad) herausgenommen und einfach getrocknet werden, oder sie können nochmals mit dem gleichen Reiniger(-Bad) oder herkömmlichen halogenhaltigen Lösungsmitteln wie Fluorchlorkohlenwasserstoffen oder chlorhaltigen Reinigern oder Reinigern des Alkohol-Typs gereinigt werden. Hierbei sind die einzusetzenden Mengen an halogenhaltigen Reinigern deutlich geringer als bei Verwendung der halogenhaltigen Reiniger im ersten Reinigungsschritt.

Vorzugsweise wird im Anschluß an die Reinigung mit Wasser gespült. Der Einsatz von Wasser ist insbesondere dann vorteilhaft, wenn entweder eine beträchtliche Menge wasserlöslicher Substanzen auf den Leiterplatten zurückbleiben oder wenn feine staubartige Rückstände dort in größeren Mengen vorhanden sind. Das hierbei zum Nachspülen verwendete Wasser ist nicht mit halogenierten Kohlenwasserstoffen verunreinigt, wie dies bei einschlägigen Reinigungsmitteln des Standes der Technik der Fall ist, sondern enthält ausschließlich biologisch abbaubare Substanzen.

Weiterhin können die Platten mit den gedruckten Schaltungen, nachdem sie der obigen Behandlung unterzogen wurden, getrocknet werden, beispielsweise bei erhöhter Temperatur in einem Trockenschrank oder einer entsprechenden Vorrichtung, durch einen Warmluftstrom oder aber durch Abwaschen mit einem leichtflüchtigen Lösungsmittel, wie Ethanol und/oder Isopropanol, das mit Wasser ein Azeotrop bildet.

Im folgenden wird die Erfindung anhand praktischer Beispiele erläutert.

### Beispiel 1

Auf eine Leiterplatte wurde ein Flußmittel auf Kolophoniumbasis aufgebracht und bei 150 bis 200 °C eingetrocknet. Die Leiterbahnen wurden daraufhin mit einem handelsüblichen Lot von Hand gelötet.

Die so behandelte Platte wurde in einer wäßrigen Lösung, die 60 Gew.-% Diacetonalkohol, 12 Gew.-% N-2-Methylpyrrolidon, 2 Gew.-% eines nichtionogenen Tensids (C₁₃-Alkyl-polyethylenglykolether mit 5 Ethylenoxideinheiten) und 1 Gew.-% eines anionaktiven Tensids (C₁₃-₁₇-Alkylsulfonsäure-Na-salz) enthielt, bei 55 °C im Verlauf von 2 min mit Ultraschall behandelt. Daraufhin wurde die Leiterplatte mit Wasser abgespült und in einem Trockenschrank getrocknet.

Die Oberfläche war nach dieser Behandlung mikroskopisch rein und auch auf den Leiterbahnen waren keinerlei Belegungen - weiße Rückstände - festzustellen.

### Beispiel 2

Eine weitere Leiterplatte wurde wie in Beispiel 1 beschrieben vorbehandelt und in einer Spritzanlage bei 55 °C und 4·10⁵Pa (4 bar) Spritzdruck 3 min lang mit einer wäßrigen Lösung von 60 Gew.-% Diacetonalkohol, 12 Gew.-% N-2-Methylpyrrolidon, 2 Gew.-% Triethanolamin, 2 Gew.-% eines nichtionogenen Tensids (C₁₃-Alkyl-polyethylenglykolether mit 5 Ethylenoxideinheiten) und 1 Gew.-% eines anionaktiven Tensids (C₁₃-₁₇-Alkylsulfonsäure-Na-salz) gereinigt.

Nach Wasserspülung und Trocknung zeigten die Oberflächen unter dem Mikroskop keinerlei Rückstände von Kolophonium und auch die Leiterbahnen waren metallisch blank, ohne jede Belegung.

### Beispiel 3

Eine mit Lotpaste versehene und mit SMD-Bausteinen bestückte Leiterplatte wurde nach dem Reflow-Löten bei 45 °C 3 min mit Ultraschall behandelt in einem Lösungsmittelgemisch, welches
86 Gew.-% Diacetonalkohol,
9 Gew.-% N-2-Methylpyrrolidon,
2 Gew.-% Triethanolamin,
2 Gew.-% C₁₃-Alkyl-polyethylenglykolether mit 5 Ethylenoxideinheiten,
1 Gew.-% C₁₃₋₁₇-Alkylsulfonsäure-Na-salz enthielt.

Anschließend wurde die Leiterplatte mit Wasser gespült und im Trockenschrank getrocknet. Die Oberfläche der Leiterplatte war nach dieser Behandlung vollkommen sauber und wies auch im Bereich der Kontaktfüße sowie in den engen Zwischenräumen unter dem SMD-Baustein keine Rückstände der Lotpaste auf.

## Patentansprüche

1. Verwendung von Diacetonalkohol zur Reinigung elektronischer und elektrischer Baugruppen in Halogenkohlenwasserstoff-freien, mit Wasser mischbaren Reinigungsmitteln, dadurch gekennzeichnet, daß die Reinigungsmittel zur Fluxmittel-Entfernung nach dem Löten eingesetzt werden und Diacetonalkohol in Mengen von 30 bis 90 Gew.-%, bezogen auf das Reinigungsmittel enthalten.

2. Verwendung nach Anspruch 1, dadurch gekennzeichnet, daß die Reinigungsmittel Diacetonalkohol in Mengen von 30 bis 80 Gew.-%, bezogen auf das Reinigungsmittel, in einer wäßrigen Lösung enthalten.

3. Verwendung nach Anspruch 2, dadurch gekennzeichnet, daß die Reinigungsmittel Diacetonalkohol in Mengen von 50 bis 70 Gew.-% in einer wäßrigen Lösung enthalten.

4. Verwendung nach einem oder mehreren der Ansprüche 1 bis 3, dadurch gekennzeichnet, daß die Reinigungsmittel anionische und/oder nichtionische Tenside in einer Menge von bis zu 10 Gew.-%, bezogen auf das Reinigungsmittel, enthalten.

5. Verwendung nach Anspruch 4, dadurch gekennzeichnet, daß die Reinigungsmittel anionische und/oder nichtionische Tenside in Mengen von 1 bis 5 Gew.-% enthalten.

6. Verwendung nach einem oder mehreren der Ansprüche 1 bis 5, dadurch gekennzeichnet, daß die Reinigungsmittel wasserlösliche organische Stickstoffbasen in Mengen von 1 bis 10 Gew.-%, bezogen auf das Reinigungsmittel, enthalten.

7. Verwendung nach Anspruch 6, dadurch gekennzeichnet, daß die Reinigungsmittel wasserlösliche organische Stickstoffbasen in Mengen von 2 bis 5 Gew.-% enthalten.

8. Verwendung nach Anspruch 7, dadurch gekennzeichnet, daß die Reinigungsmittel als wasserlösliche organische Stickstoffbase Triethanolamin enthalten.

9. Verwendung nach einem oder mehreren der Ansprüche 1 bis 8, dadurch gekennzeichnet, daß die Reinigungsmittel wasserlösliche Lösungsmittel, ausgewählt aus Alkoholen, Glykolen, Glykolethern, Glykolestern, Glykolsäureestern, Lactonen und Lactamen, in einer Menge von bis zu 30 Gew.-%, bezogen auf das Reinigungsmittel, enthalten.

10. Verwendung nach Anspruch 9, dadurch gekennzeichnet, daß die Reinigungsmittel wasserlösliche Lösungsmittel in Mengen von 5 bis 20 Gew.-% enthalten.

11. Verwendung nach Anspruch 9 oder 10, dadurch gekennzeichnet, daß die Reinigungsmittel als wasserlösliches Lösungsmittel N-Methyl-2-pyrrolidon enthalten.

12. Verwendung nach einem oder mehreren der Ansprüche 1 bis 11, dadurch gekennzeichnet, daß die Reinigungsmittel anorganische Builderstoffe aus der Gruppe der Alkalimetallphosphate in einer Menge von höchstens 5 Gew.-%, bezogen auf das Reinigungsmittel, enthalten.

13. Verwendung nach Anspruch 12, dadurch gekennzeichnet, daß die Reinigungsmittel anorganische Builderstoffe in Mengen von 1 bis 2 Gew.-% enthalten.

14. Verwendung nach einem oder mehreren der Ansprüche 1 bis 13, dadurch gekennzeichnet, daß die Reinigungsmittel Korrosionsinhibitoren in Mengen von 0,01 bis 5 Gew.-%, bezogen auf das Reinigungsmittel, enthalten.

15. Verwendung nach Anspruch 14, dadurch gekennzeichnet, daß die Reinigungsmittel Korrosionsinhibitoren in Mengen von 0,01 bis 1 Gew.-% enthalten.

16. Verwendung nach einem oder mehreren der Ansprüche 1 bis 15, dadurch gekennzeichnet, daß die Reinigung unter zusätzlicher Ultraschallbehandlung, Rühren, Vibration, Luft-Durchblasen, Flüssigkeits-Umwälzen des Reinigungsmittels oder durch Spritzen, Tauchen, Bürsten oder Fluten desselben oder Kombinationen davon vorgenommen wird.

## Claims

1. The use of diacetone alcohol for cleaning electronic and electrical assemblies in water-miscible cleaning preparations free from halogenated hydrocarbons, characterized in that the cleaning preparations are used for removing flux after soldering and contain diacetone alcohol in quantities of 30 to 90% by weight, based on the cleaning preparation.

2. The use claimed in claim 1, characterized in that the cleaning preparations contain diacetone alcohol in quantities of 30 to 80% by weight, based on the cleaning preparation, in an aqueous solution.

3. The use claimed in claim 2, characterized in that the cleaning preparations contain diacetone alcohol in quantities of 50 to 70% by weight in an aqueous solution.

4. The use claimed in one or more of claims 1 to 3, characterized in that the cleaning preparations contain anionic and/or nonionic surfactants in a quantity of up to 10% by weight, based on the cleaning preparation.

5. The use claimed in claim 4, characterized in that the cleaning preparations contain anionic and/or nonionic surfactants in quantities of 1 to 5% by weight.

6. The use claimed in one or more of claims 1 to 5, characterized in that the cleaning preparations contain water-soluble organic nitrogen bases in quantities of 1 to 10% by weight, based on the cleaning preparation.

7. The use claimed in claim 6, characterized in that the cleaning preparations contain water-soluble organic nitrogen bases in quantities of 2 to 5% by weight.

8. The use claimed in claim 7, characterized in that the cleaning preparations contain triethanolamine as the water-soluble organic nitrogen base.

9. The use claimed in one or more of claims 1 to 8, characterized in that the cleaning preparations contain water-soluble solvents selected from alcohols, glycols, glycol ethers, glycol esters, glycolic acid esters, lactones and lactams in a quantity of up to 30% by weight, based on the cleaning preparation.

10. The use claimed in claim 9, characterized in that the cleaning preparations contain water-soluble solvents in quantities of 5 to 20% by weight.

11. The use claimed in claim 9 or 10, characterized in that the cleaning preparations contain N-methyl-2-pyrrolidone as the water-soluble solvent.

12. The use claimed in one or more of claims 1 to 11, characterized in that the cleaning preparations contain inorganic builders from the group of alkali metal phosphates in a quantity of at most 5% by weight, based on the cleaning preparation.

13. The use claimed in claim 12, characterized in that the cleaning preparations contain inorganic builders in quantities of 1 to 2% by weight.

14. The use claimed in one or more of claims 1 to 13, characterized in that the cleaning preparations contain corrosion inhibitors in quantities of 0.01 to 5% by weight, based on the cleaning preparation.

15. The use claimed in claim 14, characterized in that the cleaning preparations contain corrosion inhibitors in quantities of 0.01 to 1% by weight.

16. The use claimed in one or more of claims 1 to 15, characterized in that the cleaning process is assisted by ultrasonication, stirring, vibration, blowing through of air, liquid circulation of the cleaning preparation or by spraying, immersion, brushing, flooding or combinations thereof.

## Revendications

1. Utilisation d'alcool diacécolique pour le nettoyage d'éléments électroniques et électriques, dans des produits de nettoyage miscibles avec l'eau, exempts d'hydrocarbures halogénés,
caractérisée en ce que
les produits de nettoyage sont mis en oeuvre pour l'élimination de diluants après le brasage et contiennent de l'alcool diacétonique en quantités de 30 à 90 % en poids par rapport au produit de nettoyage.

2. Utilisation selon la revendication 1,
caractérisée en ce que
les produits de nettoyage contiennent de l'alcool diacétonique, en quantités de 30 à 80 % en poids, par rapport au produit de nettoyage, dans une solution aqueuse.

3. Utilisation selon la revendication 2,
caractérisée en ce que
les produits de nettoyage contiennent de l'alcool diacétonique en quantités de 50 à 70 % en poids dans une solution aqueuse.

4. Utilisation selon une ou plusieurs des revendications 1 à 3,
caractérisée en ce que
les produits de nettoyage contiennent des tensioactifs anioniques et/ou non ioniques en une quantité allant jusqu'à 10 % en poids, par rapport au produit de nettoyage.

5. Utilisation selon la revendication 4,
caractérisée en ce que
les produits de nettoyage contiennent des tensioactifs anioniques et/ou non ioniques en quantités de 1 à 5 % en poids.

6. Utilisation selon une ou plusieurs des revendications 1 à 5,
caractérisée en ce que
les produits de nettoyage contiennent des bases d'azote organiques solubles dans l'eau en quantités de 1 à 10 % en poids, par rapport au produit de nettoyage.

7. Utilisation selon la revendication 6,
caractérisée en ce que
les produits de nettoyage contiennent des bases d'azote organiques solubles dans l'eau en quantités de 2 à 5 % en poids.

8. Utilisation selon la revendication 7,
caractérisée en ce que
les produits de nettoyage contiennent comme base d'azote organique soluble dans l'eau de la triéthanolamine.

9. Utilisation selon une ou plusieurs des revendications 1 à 8,
caractérisée en ce que
les produits de nettoyage contiennent des solvants solubles dans l'eau, choisis parmi des alcools, des glycols, des éthers de glycols, des esters de glycols, des esters d'acide glycolique, des lactones et des lactames, en une quantité allant jusqu'à 30 % en poids, par rapport au produit de nettoyage.

10. Utilisation selon la revendication 9,
caractérisée en ce que
les produits de nettoyage contiennent des solvants solubles dans l'eau en quantités de 5 à 20 % en poids.

11. Utilisation selon la revendication 9 ou 10,
caractérisée en ce que
les produits de nettoyage contiennent comme solvant soluble dans l'eau de la N-méthyl-2-pyrrolidone.

12. Utilisation selon une ou plusieurs des revendications 1 à 11,
caractérisée en ce que
les produits de nettoyage contiennent des adjuvants minéraux provenant du groupe des phosphates de métal alcalin en une quantité d'au maximum 5 % en poids, par rapport au produit de nettoyage.

13. Utilisation selon la revendication 12,
caractérisée en ce que
les produits de nettoyage contiennent des adjuvants minéraux en quantités de 1 à 2 % en poids.

14. Utilisation selon une ou plusieurs des revendications 1 à 13,
caractérisée en ce que
les produits de nettoyage contiennent des inhibiteurs de corrosion en quantités de 0,01 à 5 % en poids, par rapport au produit de nettoyage.

15. Utilisaticn selon la revendication 14,
caractérisée en ce que
les produits de nettoyage contiennent des inhibiteurs de corrosion en quantités de 0,01 à 1 % en poids.

16. Utilisation selon une ou plusieurs des revendications 1 à 15,
caractérisée en ce que
le nettoyage est entrepris par traitement additionnel d'ultrasons, agitation, vibration, soufflage d'air, circulation du liquide du produit de nettoyage ou par aspersion, immersion, brassage ou inondation du même ou par une combinaison de ces opérations.
